# EUROPEAN PATENT APPLICATION

(11) **EP 4 227 962 A1**
(43) Date of publication of application: **16.08.2023**
(21) Application number: 23153523.8
(22) Date of filing: 26.01.2023
(51) Int. Cl.: H01B 1/02, H01B 7/00, H01B 13/00

(54) **HIGH-TEMPERATURE HETEROSTRUCTURE CONDUCTOR AND METHOD OF MAKING THE SAME**

(30) Priority: 15.02.2022 US 202217651092
(71) Applicant: Honeywell International Inc., Charlotte, NC 28202 (US)
(72) Inventor: MOHAJERI, Mahdi, Charlotte, 28202 (US); PASSMAN, Eric, Charlotte, 28202 (US); JADIDIAN, Bahram, Charlotte, 28202 (US)
(74) Representative: LKGlobal UK Ltd.

(57) **Abstract**

A high-temperature heterostructure conductor includes an electrically conductive heterostructure core, a second electrically conductive material, a ceramic layer and a dielectric layer. The electrically conductive heterostructure core includes a first electrically conductive material and an intermetallic layer that is formed on and surrounds the first electrically conductive material. The second electrically conductive material surrounds the intermetallic layer. The ceramic layer is formed or disposed on and surrounds the second electrically conductive material. The dielectric layer is disposed on and surrounding the ceramic layer.

## Description

### TECHNICAL FIELD

The present invention generally relates to electrical conductors, and more particularly relates to electrical conductors, and methods of making electrical conductors, that can withstand relatively high operating temperatures.

### BACKGROUND

Conventional electrical conductors, such as organic insulated copper wire, are typically limited to long term exposure temperatures below 200°C/400°F, and 260°C/500°F short term. This, in part, is because the organic insulation materials rapidly decompose, become brittle, and ultimately fail.. Moreover, these conventional conductors begin forming a detrimental oxide layer. There is an ongoing demand for electrical conductors that can withstand temperatures above this limit. Ultimately, electrical conductors and electrical insulation capable of withstanding temperatures above 400°C/752°F long term are desired. The commercially available candidates for elevated temperature use have detrimental characteristics, such as Ni diffusion, health hazards, and easily abradable insulation.

It has been discovered that an improvement of >300°F capability can be obtained with an electrical conductor made of stainless steel clad copper wire with a glass insulating layer applied. However, this type of conductor exhibits certain drawbacks. In particular, stainless steel clad copper wire has a higher electrical resistance as compared to copper, which reduces the overall wire conductivity (IACS) as compared to a similarly sized wire of pure copper. In addition, applying the insulator glass onto the stainless clad copper wire, which is essential to obtaining the required thermal and insulative properties, requires multiple steps to reach the desired properties. Moreover, the pre-coated wire has a limited shelf-life, coating thickness limitations, and a time/cost heavy process to prepare the coating material and pre-coat the wire.

Hence, there is a need for an electrical conductor that can withstand temperatures above 200°C/400°F long term, and even above 400°C/752°F, that does not have a limited shelf-life, does not exhibit coating thickness limitations, does not rely on a time-consuming and costly process, and/or does not exhibit a significantly higher electrical resistance as compared to copper. The present invention addresses at least these needs.

### BRIEF SUMMARY

This summary is provided to describe select concepts in a simplified form that are further described in the Detailed Description. This summary is not intended to identify key or essential features of the claimed subject matter, nor is it intended to be used as an aid in determining the scope of the claimed subject matter.

In one embodiment, a high-temperature heterostructure conductor includes an electrically conductive heterostructure core, a second electrically conductive material, a ceramic layer and a dielectric layer. The electrically conductive heterostructure core includes a first electrically conductive material and an intermetallic layer that is formed on and surrounds the first electrically conductive material. The second electrically conductive material surrounds the intermetallic layer. The ceramic layer is formed or disposed on and surrounds the second electrically conductive material. The dielectric layer is disposed on and surrounding the ceramic layer.

In another embodiment, a high-temperature heterostructure conductor, includes an electrically conductive heterostructure core, a second electrically conductive material, a ceramic layer and a dielectric layer. The electrically conductive heterostructure core includes a first electrically conductive material and an intermetallic layer that is formed on and surrounds the first electrically conductive material. The second electrically conductive material surrounds the intermetallic layer. The ceramic layer is formed on and surrounds the second electrically conductive material. The dielectric layer is formed or disposed on and surrounds the ceramic layer. The intermetallic layer comprises aluminum (Al) and nickel (Ni). The ceramic layer comprises a film of carbide or nitride (TiC, SiC, AlN, SiN), and the dielectric layer comprises an organic or inorganic material such as a glass, a ceramic, or a glass ceramic.

In yet another embodiment, a method of forming a high-temperature heterostructure conductor, includes forming a multilayer conductor that comprises a first electrically conductive material and a plurality of metallic materials; disposing a dielectric material over at least the multilayer conductor; and exposing at least the multilayer conductor and the dielectric material to a finishing heat treatment to thereby form: an electrically conductive heterostructure core, which comprises the first electrically conductive material and an intermetallic layer; a second electrically conductive material surrounding the intermetallic layer; a ceramic layer on the second electrically conductive material; and a dielectric layer disposed on and surrounding the ceramic layer.

Furthermore, other desirable features and characteristics of the high-temperature conductor will become apparent from the subsequent detailed description and the appended claims, taken in conjunction with the accompanying drawings and the preceding background.

### BRIEF DESCRIPTION OF THE DRAWINGS

The present invention will hereinafter be described in conjunction with the following drawing figures, wherein like numerals denote like elements, and wherein:
FIG. 1 is a cross section view of one embodiment of a high-temperature heterostructure conductor upon final processing;
FIG. 2 depicts embodiments of multiple example methods, in flowchart form, for fabricating the high-temperature heterostructure conductor of FIG. 1; and
FIG. 3 depicts the example methods of FIG. 2 schematically.

### DETAILED DESCRIPTION

The following detailed description is merely exemplary in nature and is not intended to limit the invention or the application and uses of the invention. As used herein, the word "exemplary" means "serving as an example, instance, or illustration." Thus, any embodiment described herein as "exemplary" is not necessarily to be construed as preferred or advantageous over other embodiments. All of the embodiments described herein are exemplary embodiments provided to enable persons skilled in the art to make or use the invention and not to limit the scope of the invention which is defined by the claims. Furthermore, there is no intention to be bound by any expressed or implied theory presented in the preceding technical field, background, brief summary, or the following detailed description.

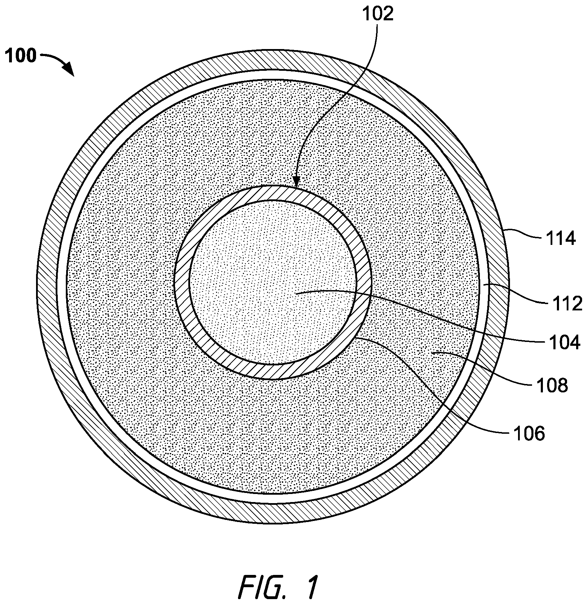

Referring to FIG. 1, a cross section view of one embodiment of a high-temperature heterostructure conductor 100 is depicted. It will be appreciated that although the depicted heterostructure conductor 100 has a circular cross section, it can also be manufactured to have various other cross-sectional shapes. For example, it could be manufactured to have an elliptical cross-sectional shape, a square cross-sectional shape, a rectangular cross-sectional shape, or various other rhombus cross-sectional shapes, just to name a few.

No matter the specific cross-sectional shape, the fully processed high-temperature heterostructure conductor 100 includes an electrically conductive heterostructure core 102, which comprises a first electrically conductive material 104 and an intermetallic layer 106. The heterostructure conductor 100 also includes a second electrically conductive material 108, a ceramic layer 112, and a dielectric layer 114. The first electrically conductive material 104 is preferably copper (Cu). However, various other electrically conductive materials may alternatively be used. Some non-limiting examples include aluminum (Al), silver (Ag), platinum (Pt), palladium (Pd), and various alloys, such as Cu alloys, Ag/Pt alloys, and Pt/Rh (rhodium) alloys, just to name a few.

The intermetallic layer 106 is formed on and surrounds the first electrically conductive material 104. The intermetallic layer 106 blocks, or at least reduces, interdiffusion due to electromigration of the second electrically conductive material 108 into the first electrically conductive material 104, thereby eliminating, or at least minimizing, changes in the conductivity of the first electrically conductive material 104. The intermetallic layer 106 may be formed from various types of metallic materials. In one embodiment, the intermetallic layer 106 is formed from aluminum (Al) 108 and nickel (Ni). It will be appreciated, however, that various other materials may be used. Some non-limiting examples of other materials include titanium (Ti), and numerous other metallic materials that do not form a solid solution with the first electrically conductive material 104, just to name a few. When Al (108) and Ni (106) are used, the Ni preferably has a thickness of less than 5 microns, and most preferably less than 1 micron.

The second electrically conductive material 108 surrounds the intermetallic layer 106. The second electrically conductive material 108 is preferably aluminum (Al). However, various other electrically conductive materials may also be used, provided it will react with the intermetallic precursor material at 106 to form the final desired intermetallic material. Some non-limiting examples include chromium (Cr), Cu, Pt, Pd, and Rh, just to name a few. No matter the specific electrically conductive materials that are used for the first and second electrically conductive materials 104 and 108, the materials are preferably selected so that the density ratio between the first electrically conductive material 104 and the second electrically conductive material 108 is in a range of 2-4 to achieve maximum electrical conductivity while minimizing the weight of the heterostructure's electrically conductive core.

In addition to the preferred density ratio range, there is also a preferred geometric ratio range associated with the first and second electrically conductive materials 104 and 108. In particular, and as FIG. 1 depicts, the cross-sectional area of the second electrically conductive material 108 is greater than that of the first electrically conductive material 104. Thus, the cross-sectional area ratio between the first electrically conductive material 104 and the second electrically conductive material 108 is preferably less than 1.0. In one particular embodiment, for the purposes of achieving maximum electrical conductivity while minimizing overall density, the first electrically conductive material 104 is Cu and the second electrically conductive material 108 is Al, preferably in a ratio in the range of about 0.5-0.66

The ceramic layer 112 surrounds the second electrically conductive material 108. The ceramic layer 112 can be formed on the second conductor 108 in-situ or via deposition of an additional material using various processes. For example, the ceramic layer 112 may be a film of in-situ formed alumina (Al₂O₃) during a thermal processing step, or a deposited film of a suitable carbide (e.g., TiC, SiC) or a suitable nitride (e.g., AlN, SiN). It will be appreciated, however, that various other ceramics may be used, typically based on the material of the second conductor material 108 or the deposited film.

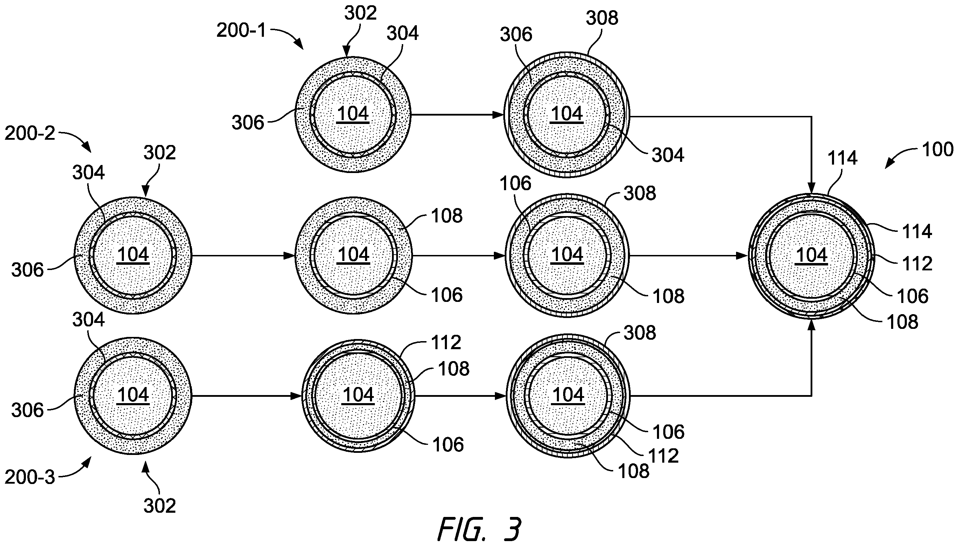

The dielectric layer 114 surrounds the ceramic layer 112. As will be described further below, a dielectric pre-cursor layer 308 (see FIG. 3) is deposited or formed around the ceramic layer 112 and may comprise an organic or inorganic dielectric material. Depending on the material of the dielectric pre-cursor layer 308, a thermal processing step may be required. For high temperature applications, the fully processed dielectric layer 114 will be an inorganic material such as, for example, a glass, a ceramic, or a glassceramic. Alternatively, the fully processed dielectric layer 114 can be an organic dielectric material such as, for example, polyimides, polyesters, or silicones. It will be appreciated, however, that various other dielectric materials may be used and can be dependent on the specific electrical conductor application needs.

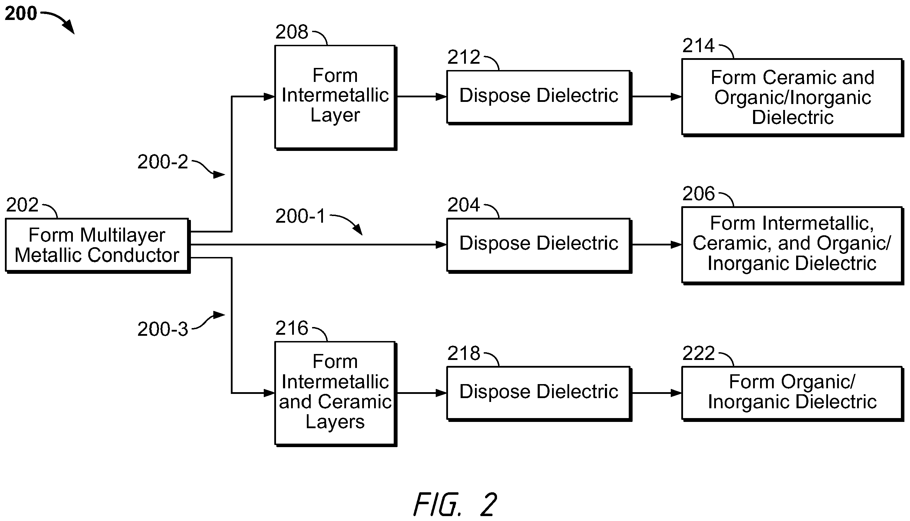

Having described the overall structure of the high-temperature heterostructure conductor 100, a description will now be provided of a method 200 for fabricating the high-temperature heterostructure conductor 100. In doing so, reference should be made to FIGS. 2, which depicts multiple example methods 200 in flowchart, in combination with FIG. 3, which depicts the multiple example methods 200 schematically. As these figures illustrate, the example methods 200 demonstrate three different routes to fabricate the high-temperature heterostructure conductor 100, though certainly other, additional routes could be used. It should be noted that the parenthetical numerals refer to like numerals in the flowchart in FIG. 2.

As FIG. 2 depicts, the method 200 begins by firstly forming a multilayer conductor 302 (202). This is done, as shown in FIG. 3, by disposing the metallic materials 304 and 306 that comprise the intermetallic layer 106 on the first electrically conductive material 104. This may be done using various processes. Some examples of suitable processes include, but are not limited to, cladding via coldworking, cladding via post hot isostatic pressing (HIP) and drawing, electroplating layers on the first electrically conductive material 104, electroless plating on the first electrically conductive material 104, physical vapor deposition on the first electrically conductive material 104, roll casting on the first electrically conductive material 104, and co-extrusion of the first electrically conductive material 104 and the metallic materials 304, 306 that comprise the intermetallic layer 106. As previously noted, the metallic materials 304, 306 that comprise the intermetallic layer 106 may include nickel (Ni) 304 and aluminum (Al) 306, but various other metallic materials may be used.

Thereafter, and as FIGS. 2 and 3 depict, one of the routes 200-1 includes proceeding directly to disposing the dielectric pre-cursor layer 308 onto the multilayer conductor 302 (204) and then forming the high-temperature heterostructure conductor 100 by subjecting the multilayer conductor 302 and dielectric pre-cursor layer 308 to a heat treatment process 206. The manner in which the dielectric pre-cursor layer 308 is disposed onto the multilayer conductor 302 may vary. In one particular embodiment, the dielectric pre-cursor layer 308 is disposed onto the multilayer conductor by wet winding, dip coating, spraying, or drawing, just to name a few examples. It will additionally be appreciated that the particular heat treatment process may vary and may depend, for example, on the metallic core material 104, materials 304 and 306 that comprise the intermetallic layer 106, and/or the material or materials that comprise the dielectric pre-cursor layer 308. In one particular example, the metallic materials 302 and 304 that comprise the intermetallic layer 106 are nickel (Ni) 304 and aluminum (Al) 302 and the dielectric pre-cursor layer 308 comprises a glass, for example. The structure is then subjected to a single heat treatment process 206 that includes controlled atmosphere thermal processing at a temperature of about 550°C to about 650°C to create the final forms of the heterostructure conductor 100 which includes the intermetallic 106, ceramic 112, and dielectric 114 layers. It will be appreciated, however, that the atmosphere and temperature may vary and may be dependent upon all of the materials used to form the heterostructure conductor 100.

In accordance with another one of the routes 200-2, the multilayer conductor 302 undergoes a first heat treatment process 208 to form the heterostructure core 102. More specifically, the first heat treatment process 208 is used to form the intermetallic layer 106 on the first electrically conductive material 104. The first heat treatment process 208 may be a single step or a multi-step process. In one particular embodiment, in which the intermetallic layer 106 is formed from nickel (Ni) 304 and aluminum (Al) 302, the heat treatment process is at a temperature of about 350°C to about 650°C, whereby the intermetallic layer 106, and thus the heterostructure core 102, is formed. Thereafter, this route 200-2 proceeds to the step of disposing the dielectric 114 onto the heterostructure core 212 and then forming the high-temperature heterostructure conductor 100 by subjecting the multilayer conductor 302 and dielectric 114 to a heat treatment process 214. The manner in which the dielectric 114 is disposed onto the multilayer conductor 302, the manner in which the ceramic layer 112 is created, and the heat treatment process may be, for example, the same as those described above with respect to route 200-1.

In accordance with yet another one of routes 200-3, the multilayer conductor 302 undergoes a heat treatment process to simultaneously form the heterostructure core 102 (i.e., the intermetallic layer 106 on the first electrically conductive material 104) and the ceramic layer 112 (216). In one particular embodiment, in which the intermetallic layer 106 is formed from nickel (Ni) 304 and aluminum (Al) 302, the heat treatment process is conducted at a temperature of about 350° to about 650°C, whereby an Al-Ni intermetallic layer 106, and thus the heterostructure core 102, is formed, and simultaneously a film of alumina (Al₂O₃) (i.e., the ceramic layer 112) is formed on the outer surface of the second electrically conductive material 108 (aluminum). Thereafter, this route 200-3 also proceeds to the step of disposing the dielectric 114 onto the ceramic layer 112 (218) and then forming the high-temperature heterostructure conductor 100 by subjecting the heterostructure core 102, the second electrically conductive material 108, the ceramic layer 112, and the dielectric 114 to a heat treatment process 222. Again, the manner in which the dielectric 114 is disposed onto the multilayer conductor 302 and the heat treatment process may vary, and may be, for example, the same as those described above with respect to route 200-1.

In this document, relational terms such as first and second, and the like may be used solely to distinguish one entity or action from another entity or action without necessarily requiring or implying any actual such relationship or order between such entities or actions. Numerical ordinals such as "first," "second," "third," etc. simply denote different singles of a plurality and do not imply any order or sequence unless specifically defined by the claim language. The sequence of the text in any of the claims does not imply that process steps must be performed in a temporal or logical order according to such sequence unless it is specifically defined by the language of the claim. The process steps may be interchanged in any order without departing from the scope of the invention as long as such an interchange does not contradict the claim language and is not logically nonsensical.

Furthermore, depending on the context, words such as "connect" or "coupled to" used in describing a relationship between different elements do not imply that a direct physical connection must be made between these elements. For example, two elements may be connected to each other physically, electronically, logically, or in any other manner, through one or more additional elements.

As used herein, the term "axial" refers to a direction that is generally parallel to or coincident with an axis of rotation, axis of symmetry, or centerline of a component or components. For example, in a cylinder or disc with a centerline and generally circular ends or opposing faces, the "axial" direction may refer to the direction that generally extends in parallel to the centerline between the opposite ends or faces. In certain instances, the term "axial" may be utilized with respect to components that are not cylindrical (or otherwise radially symmetric). For example, the "axial" direction for a rectangular housing containing a rotating shaft may be viewed as a direction that is generally parallel to or coincident with the rotational axis of the shaft. Furthermore, the term "radially" as used herein may refer to a direction or a relationship of components with respect to a line extending outward from a shared centerline, axis, or similar reference, for example in a plane of a cylinder or disc that is perpendicular to the centerline or axis. In certain instances, components may be viewed as "radially" aligned even though one or both of the components may not be cylindrical (or otherwise radially symmetric). Furthermore, the terms "axial" and "radial" (and any derivatives) may encompass directional relationships that are other than precisely aligned with (e.g., oblique to) the true axial and radial dimensions, provided the relationship is predominantly in the respective nominal axial or radial direction. As used herein, the term "substantially" denotes within 5% to account for manufacturing tolerances. Also, as used herein, the term "about" denotes within 5% to account for manufacturing tolerances.

While at least one exemplary embodiment has been presented in the foregoing detailed description of the invention, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention. It being understood that various changes may be made in the function and arrangement of elements described in an exemplary embodiment without departing from the scope of the invention as set forth in the appended claims.

## Claims

1. A high-temperature heterostructure conductor, comprising:
an electrically conductive heterostructure core comprising a first electrically conductive material and an intermetallic layer formed on and surrounding the first electrically conductive material;
a second electrically conductive material surrounding the intermetallic layer;
a ceramic layer formed or disposed on and surrounding the second electrically conductive material; and
a dielectric layer disposed on and surrounding the ceramic layer.

2. The high-temperature heterostructure conductor of claim 1, wherein the intermetallic layer and ceramic layer are formed during the formation of the dielectric layer.

3. The high-temperature heterostructure conductor of claim 1, wherein the intermetallic layer is formed during formation of the dielectric layer.

4. The high-temperature heterostructure conductor of claim 1, wherein the intermetallic layer is formed prior to the formation of the dielectric layer.

5. The high-temperature heterostructure conductor of claim 1, wherein the dielectric layer comprises an organic material such as a glass, a ceramic, or a glass ceramic, or an inorganic material such as polyamide, polyester, or silicone.

6. The high-temperature heterostructure conductor of claim 1, wherein the intermetallic layer comprises aluminum (Al) and nickel (Ni).

7. The high-temperature heterostructure conductor of claim 6, wherein the intermetallic layer is formed at a temperature in a range of about 300°C to 550°C,
whereby:
an Al-Ni intermetallic layer is formed; and
a ceramic film of alumina (Al₂O₃) is formed on an outer surface of the second electrically conductive layer.

8. The high-temperature heterostructure conductor of claim 6, wherein the Ni has a thickness of less than 5 microns.

9. The high-temperature heterostructure conductor of claim 6, wherein the Ni has a thickness of less than 1 micron.

10. The high-temperature heterostructure conductor of claim 1, wherein the ceramic layer comprises a film of carbide or nitride (TiC, SiC, AlN, SiN).

11. The high-temperature heterostructure conductor of claim 1, wherein a cross-sectional area ratio between the first electrically conductive material and the second electrically conductive material is less than 1.0.

12. The high-temperature heterostructure conductor of claim 1, wherein a density ratio between the first electrically conductive material and the second electrically conductive material is in a range of 2-4.

13. A method of forming a high-temperature heterostructure conductor, comprising the steps of:
forming a multilayer conductor that comprises a first electrically conductive material and a plurality of metallic materials;
disposing a dielectric material over at least the multilayer conductor; and
exposing at least the multilayer conductor and the dielectric material to a finishing heat treatment to thereby form:
an electrically conductive heterostructure core, which comprises the first electrically conductive material and an intermetallic layer,
a second electrically conductive material surrounding the intermetallic layer,
a ceramic layer on the second electrically conductive material; and a dielectric layer disposed on and surrounding the ceramic layer.
